# EUROPEAN PATENT APPLICATION

(11) **EP 2 940 730 A1**
(43) Date of publication of application: **04.11.2015**
(21) Application number: 15162541.5
(22) Date of filing: 07.04.2015
(51) Int. Cl.: H01L 23/552, H01L 23/66, H01L 25/00, H01L 23/00

(54) **METHOD OF MANUFACTURING ELECTRONIC COMPONENT**

(30) Priority: 11.04.2014 JP 2014082350
(71) Applicant: Shimane Masuda Electronics Co., Ltd., Masuda-shi, Shimane 698-2144 (JP)
(72) Inventor: Hirose, Noriaki, Masuda-shi, Shimane 6982144 (JP); Miura, Youhei, Masuda-shi, Shimane 6982144 (JP); Koyama, Shinpei, Masuda-shi, Shimane 6982144 (JP); Ishikawa, Satoshi, Masuda-shi, Shimane 6982144 (JP); Seii, Yoshiyuki, Masuda-shi, Shimane 6982144 (JP); Kobayashi, Mitsuru, Masuda-shi, Shimane 6982144 (JP)
(74) Representative: TBK

(57) **Abstract**

Component parts are mounted on a top surface of a ceramic substrate (1) having therein a ground line (5) including a ground layer (5c) electrically connected to a grounding portion (9a) exposed on a bottom surface of the ceramic substrate (1), and then coated with a mold resin layer (2). Half-cut is performed on the ceramic substrate (1) from the surface of the mold resin layer to expose a portion of the ground line from side surface of the ceramic substrate (1). A conductive shield film is so formed to cover the surface of the mold resin layer (2) and the exposed portion of the ground line (5) by the half-cut. A slits (3) for dividing the ceramic substrate (1) into individual electronic components (10)is formed before the dividing the ceramic substrate. The ceramic substrate (1) is divided into the individual electronic components (10) by the slit (3).

## Description

### BACKGROUND OF THE INVENTION

### Field of the Invention

The present invention relates to a method of manufacturing an electronic component which is used in various electronic devices such as communication devices and which is suitable for use in a high-frequency environment.

### Description of the Related Art

In recent years, electronic components used in various electronic devices such as communication devices have been reduced in size and have been increased in degree of integration. For example, the following three arrangements are known as such electronic components.

1) There is an electronic component in which component parts are encapsulated in a mold resin layer. This arrangement of electronic component is manufactured by mounting the component parts on a ceramic substrate for multiple components, applying the mold resin layer over an entire surface of the ceramic substrate where the component parts are mounted thereon, and then dividing the ceramic substrate along slits formed on the substrate in advance.

2) There is an electronic component in which component parts mounted on a ceramic substrate are sealed by a metal can. This arrangement of electronic component is manufactured by mounting the component parts on the ceramic substrate for multiple components and then soldering the metal can on a surface of each of individual pieces of the ceramic substrate divided along slits formed on the ceramic substrate in advance. By the soldering, the metal can is electrically connected to an electrode on the surface or a side surface of the ceramic substrate, and thereby the metal can is connected to the ground. This provides a shielding effect.

3) There is an electronic component in which component parts are mounted in a ceramic cavity and sealed by a metal lid. This arrangement of electronic component is manufactured by mounting the component parts in a ceramic package with a cavity and by solder-sealing the ceramic package with the metal lid. By the solder-sealing, the metal lid is electrically connected to an electrode on the surface or an end surface of the ceramic cavity, and thereby the metal lid is connected to the ground. This also provides a shielding effect.

In addition to the three arrangements described above, there is known an arrangement disclosed in Japanese Patent Laid-Open No. H11-163583(1999). In Japanese Patent Laid-Open No. H11-163583(1999), component parts such as an IC are mounted on an assembly substrate made of an insulating material such as glass-epoxy resin and are encapsulated by an encapsulating body made of epoxy resin. Then, the assembly substrate is half-diced with slits while a lower half of the assembly substrate remains uncut. Then, the entire periphery of the encapsulating body including the slits is plated by nickel. Thereafter, the assembly substrate is further diced to be completely separated into pieces, and electronic component packages are thereby manufactured. In each of the electronic component packages, the nickel plating also comes into contact with a grounding electrode pattern of a substrate surface, thereby the grounding electrode pattern being electrically connected to a ground connection terminal formed of a through-hole electrode, thus providing a shielding effect.

### SUMMARY OF THE INVENTION

However, the conventional electronic components described above have problems respectively. In the first arrangement, although individual molded packages in each of which the component parts are mounted on the ceramic substrate can be manufactured by the aforementioned manufacturing method, the individual mold packages cannot be provided with the shielding effect. In order to use the molded package in a high-frequency environment, an electromagnetic field and the like generated by the component parts should be prevented from affecting the outside of the component parts. Accordingly, the molded package should be shielded inside a casing of the electronic device, and this hinders size reduction and thickness reduction of the device.

In the second arrangement, the metal can is soldered, so that this increases the production cost and the material cost for the metal can. Moreover, since a land for soldering the metal can is required, size reduction is hindered. Furthermore, since the metal can is attached, a certain amount of height and a certain amount of thickness are required for the attachment, and this hinders the thickness reduction.

In the third arrangement, since assembly is performed by handling a ceramic package, the production cost is high. Moreover, this requires high material cost for the metal lid, the ceramic package with a cavity, and the like.

The arrangement disclosed in Japanese Patent Laid-Open No. H11-163583(1999) uses a method of manufacturing an electronic component using a substrate material which is easily processed, like a substrate made of insulating material such as glass epoxy resin. However, it is difficult to process a ceramic substrate having an excellent high-frequency property, and this method requires the dicing process of the substrate to be performed multiple times. For these reasons, it is not easy to manufacture an electronic component using the ceramic substrate which is a material difficult to be processed.

As described above, the arrangements have some sort of problems in achieving the size reduction, the thickness reduction, and the cost reduction of an electronic device usable in a high-frequency environment, since: the high-frequency property is poor; the manufacturing efficiency is poor so that the production cost is increased; the material cost is increased; the size reduction and the thickness reduction are hindered; and the manufacturing process is not easy.

The present invention has been made in view of the aforementioned problems in the conventional art, and an object of the present invention is to provide a method of manufacturing an electronic component, in such a way that a structure having a shielding effect for component parts mounted on a ceramic substrate can be formed without using a metal can or a metal lid, thereby reducing the size, the thickness, and the cost of an electronic device suitable for use in a high-frequency environment.

In order to solve the problems described above, in the invention described in an embodiment, a plurality of component parts are mounted on a first main surface of a ceramic substrate having therein a ground line including a ground layer electrically connected to a grounding portion exposed on a second main surface of the ceramic substrate, and then the first main surface of the ceramic substrate is coated with a mold resin layer in such a way that the plurality of component parts are covered with the mold resin layer. The ceramic substrate is diced by one half depth of the thickness of the substrate from the surface of the mold resin layer (so called "half-cut") to expose a portion of the ground line from a side surface of the ceramic substrate. A conductive shield film is formed in such a way that the conductive shield film covers the surface of the mold resin layer and the exposed portion of the ground line exposed by the half-cut. A slit for dividing the ceramic substrate into a plurality of individual electronic components is formed in advance of dividing the ceramic substrate. The ceramic substrate is divided into a plurality of individual electronic components by the slit.

Further features of the present invention will become apparent from the following description of exemplary embodiments with reference to the attached drawings.

### BRIEF DESCRIPTION OF THE DRAWINGS

FIG. 1 is a cross-sectional view showing an example of an electronic component manufactured by a manufacturing method of the present invention;
FIGS. 2A to 2F are views for explaining respective steps in a first embodiment;
FIG. 3 is a flowchart explaining the steps in a manufacturing method of the first embodiment;
FIGS. 4A to 4E are views for explaining respective steps in a second embodiment;
FIG. 5 is a flowchart explaining the steps in a manufacturing method of the second embodiment;
FIGS. 6A to 6F are views for explaining respective steps in a third embodiment; and
FIG. 7 is a flowchart explaining the steps in a manufacturing method of the third embodiment.

### DESCRIPTION OF THE EMBODIMENTS

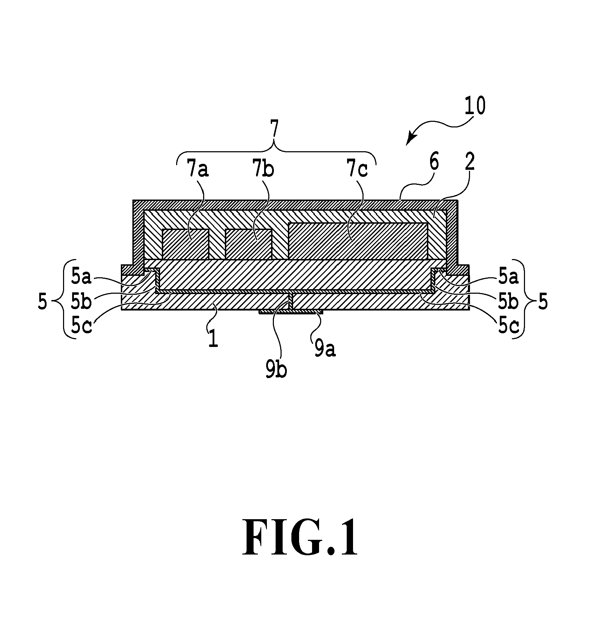

FIG. 1 is a cross-sectional view showing an example of an electronic component manufactured by a manufacturing method according to one embodiment. An electronic component 10 shown in FIG. 1 is formed by encapsulating multiple component parts 7a, 7b, 7c mounted on a first main surface on a top surface of a ceramic substrate 1 by a mold resin layer 2 and then by coating the mold resin layer 2 and the top surface of the ceramic substrate 1 by an electrically-conductive shield film 6. The ceramic substrate 1 may have, for example, a multi-layer configuration in which multiple ceramic layers are laminated one on another, and a circuit pattern and a ground line 5 are arranged between the multiple ceramic layers of the ceramic substrate 1 (interlaminar arrangement). For example, the ground line 5 includes a ground layer 5c formed between the layers, and the ground layer 5c is formed to be electrically connected to a ground lead-out portion 5a via a via 5b, the ground lead-out portion 5a exposed on each of side surfaces of the ceramic substrate 1. The ground lead-out portion 5a is formed, for example, in a ring shape at a position between the layers of the ceramic substrate 1 in a portion surrounding the component parts 7a to 7c encapsulated in the electronic component 10, and is exposed to a side surface of the ceramic substrate 1. For example, the ground line 5 is connected to a grounding portion 9a via a via 9b. The grounding portion 9a is exposed to a second main surface on a bottom surface of the ceramic substrate 1 (the main surface of the ceramic substrate 1 opposite to the main surface on which the component parts 7a to 7c are mounted).

A surface of the mold resin layer 2 and exposed portions of the ground lead-out portion 5a exposed on the side surface of the ceramic substrate 1 are coated with the conductive shield film 6, so that the conductive shield film 6 is electrically connected to the ground line 5. The electronic component 10 is so packaged that the bottom surface of the ceramic substrate 1 faces a substrate in a device on which the electronic component 10 is to be packaged. The grounding portion 9a connected to the conductive shield film 6 and the ground line 5 via the via 9b is grounded by the grounding portion 9a contact with a ground electrode of the substrate in the device on which the electronic component 10 is to be packaged. The conductive shield film 6 and the ground line 5 thereby exhibit a shielding effect. This shielding effect makes the electronic component 10 suitable for use in a high-frequency environment.

The shield film 6 for exhibiting the shielding effect of the electronic component 10 can be formed by printing or plating, and this method can reduce the size, thickness, and cost of the electronic component even in a case of using a ceramic substrate. Specifically, since the electronic component 10 is manufactured by using the mold resin and the shield film, which are low cost, instead of using a metal can, a metal lid, or a ceramic package with a cavity, the cost of material can be reduced. Moreover, the thickness and size of the component can be reduced compared to a case of sealing component parts with a metal can, because there is no need to consider a clearance in attachment of the metal can, land dimensions of soldering portions, and the like.

In a method of manufacturing the electronic component described above, the multiple component parts are mounted on the top surface of the ceramic substrate 1 having therein the ground line 5 electrically connected to the grounding portion 9a exposed on the bottom surface of the ceramic substrate 1, and then the top surface of the ceramic substrate 1 is coated with the mold resin layer 2 in such a way that a plurality of component parts are covered. The ceramic substrate 1 is half-cut from the surface of the mold resin layer 2, so that a portion of the ground line 5 is exposed from the side surface of the ceramic substrate 1. The conductive shield film 6 is so formed to cover the surface of the mold resin layer 2 and the exposed portions of the ground line 5 exposed by the half-cut. In this case, slits 3 are formed in portions where the ceramic substrate 1 is to be divided into the multiple individual electronic components, in advance of the dividing. The ceramic substrate 1 is divided into a plurality of individual electronic components 10 by the slits 3.

In the half-cut of the ceramic substrate 1, dicing is performed from the surface on which the mold resin layer 2 is formed, the ceramic substrate 1 is cut until at least the ground lead-out portion 5a is exposed on the side surface of the ceramic substrate 1, so that the half-cut ceramic substrate 1 is formed with the ground lead-out portion 5a being exposed. This half-cut ceramic substrate 1 is coated with the conductive shield film 6 over the mold resin layer 2 in such a way that a part of the shield film 6 is electrically connected to the ground lead-out portion 5a exposed on the half-cut surfaces. The ceramic substrate 1 thus coated with the shield film 6 as described above is divided into the individual electronic components along the slits 3 provided in the ceramic substrate 1.

In other words, in the method of manufacturing an electronic component according to the present invention, there is no need to individually attach metal cans or metal lids to the ceramic substrate or to a ceramic package with a cavity, and the substrate is coated with the conductive shield film in one operation and divided into individual components. Accordingly, the manufacturing efficiency is high and the cost can be reduced. Moreover, in a case of dividing the substrate into individual components, the substrate is not cut by a dicer but is divided along the slits 3 provided in the ceramic substrate 1. The substrate can be thus easily divided into individual components. Hence, it is possible to enhance the productivity of the electronic components and reduce the cost.

The method of manufacturing an electronic component in the present invention is described below based on embodiments. It is to be noted that there are various configurations of a lead-out electrode of the ground line. While description is made in FIG. 1 by making the grounding portion 9a exposed on the bottom surface of the ceramic substrate 1 and the via 9b for connection as an example of the lead-out electrode of the ground line, the present invention is not limited to this embodiment and the ground can be lead out by other configuration. In the following embodiment, illustration of the grounding portion 9a and the via 9b are omitted.

### (First Embodiment)

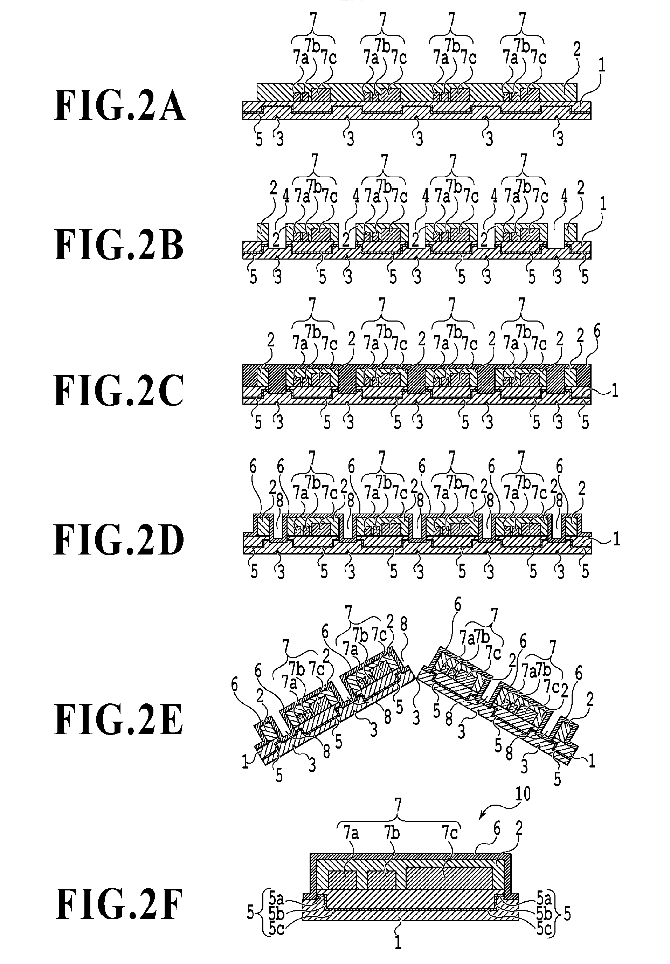

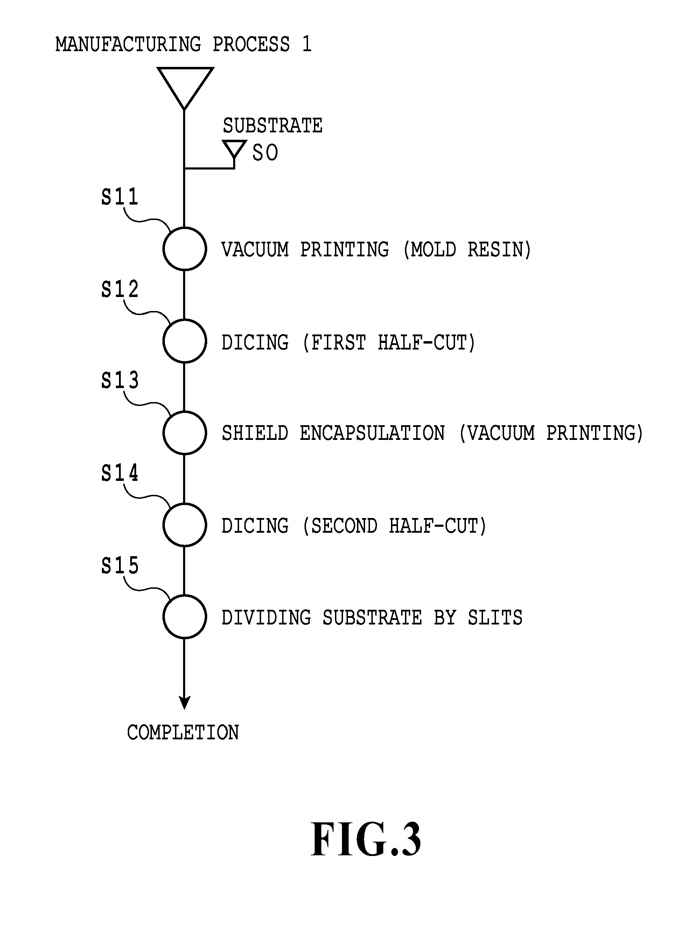

A method of manufacturing an electronic component according to a first embodiment is described by referring to FIGS. 2A to 2F and FIG. 3. FIGS. 2A to 2F are views for explaining a step in the first embodiment and FIG. 3 is a flowchart explaining the steps in the manufacturing method according to the first embodiment. In the first embodiment, the conductive shield film is formed by vacuum printing and half-cut processing.

First, as shown in FIG.3, the ceramic substrate 1 on which a plurality of component parts 7a, 7b, 7c (hereafter, collectively referred to as reference numeral 7) are mounted on the top surface is prepared (S0). The plurality of component parts 7 are capacitors and the like provided in the electronic component 10. In order to manufacture a plurality of electronic components 10 by dividing the ceramic substrate 1 into multiple pieces, the plurality of component parts 7 are arranged such that the component parts 7 forming each of the electronic components 10 are grouped together. For example, a substrate having a multi-layer configuration in which a plurality of ceramic layers are laminated one on another can be used as the ceramic substrate 1. A circuit pattern and the ground line 5 can be disposed between the layers of the ceramic substrate 1. For example, a Low-Temperature Co-fired Ceramic (LTCC) substrate can be used as the ceramic substrate 1. The ceramic substrate 1 made of ceramic material has excellent loss characteristics at high frequency.

The mold resin layer 2 is applied onto the ceramic substrate 1 to cover the entire surface of the substrate 1 to encapsulate the mounted component parts 7 (FIG. 2A, S11). The mold resin layer 2 can be applied by, for example, vacuum printing. However, the method of this application is not limited to this vacuum printing and the mold resin layer 2 can be applied by any method such as a transfer method or a compression mold method. The slits 3 are formed on the bottom surface of the ceramic substrate 1. For example, the slits 3 can be formed as V-shaped cut by a dicer. Positions where the slits are formed correspond to positions where the ceramic substrate 1 is to be divided into the individual electronic components 10.

Next, half-cut is performed by dicing from the surface of the mold resin layer 2 at positions corresponding to the slit positions to form notches 4 (FIG. 2B, S12). The notches 4 are formed by performing half-cut by a dicer to such a depth that the ground lead-out portion 5a within the ceramic substrate 1 is exposed on the side surface of the ceramic substrate 1.

Furthermore, the conductive shield film 6 is formed by performing vacuum printing on the ceramic substrate 1 having the half-cut notches 4 (FIG. 2C, S13). For example, Ag epoxy resin can be used as shield resin forming the conductive shield film 6. However, the shield resin is not limited to Ag epoxy resin, but any conductive resin can be used.

Next, second half-cut is performed on the shield film 6 at positions corresponding to the positions of the slits 3 (FIG. 2D, S14). In the second half-cut, only the shield film 6 is cut to form half-cut notches 8 for dividing. Since there is no need to cut the ceramic substrate 1 in the second half-cut process, there is an advantage that this processing is easier than that in a case of performing full-cut. While the dividing can be performed without this half-cut step, it is preferable to form the half-cut notches 8 by the half-cut in order to improve the accuracy of dividing.

Next, the ceramic substrate 1 having the half-cut notches 8 is divided into pieces by each of the slits 3 (FIG. 2E, S15).

In this manufacturing method, an electronic component suitable for use in a high-frequency environment can be made smaller and thinner and also can be manufactured at low cost.

### (Second Embodiment)

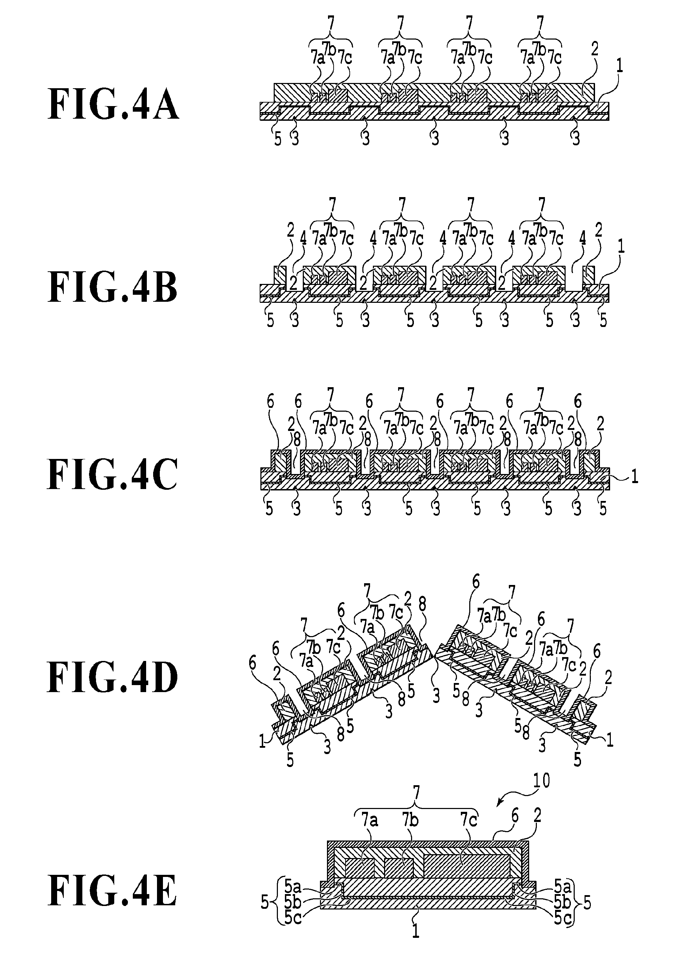

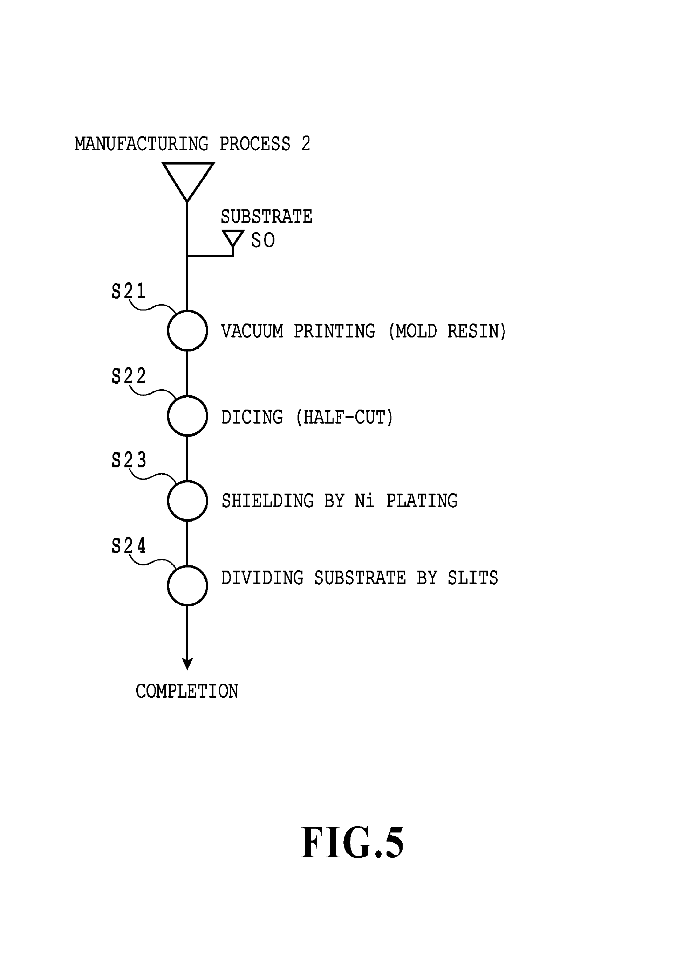

A method of manufacturing an electronic component according to a second embodiment is described by referring to FIGS. 4A to 4E and FIG. 5. FIGS. 4A to 4E are views for explaining steps in the second embodiment and FIG. 5 is a flowchart explaining the steps in the manufacturing method according to the second embodiment. While the conductive shield film 6 is formed by vacuum printing and the half-cut processing in the first embodiment, the conductive shield film 6 is formed by plating in this second embodiment. Other steps in the second embodiment are the same as those in the first embodiment.

Half-cut is performed on the mold resin layer 2 by a method similar to that in steps S0 to S12 in the first embodiment (FIGS. 4A and 4B, S0, S21, and S22).

Then, the shield film 6 is formed by plating surfaces of the notches 4, i.e. the surface of the mold resin layer 2 and the side surface of the ceramic substrate 1 including the ground lead-out portion 5a exposed by the half-cut processing (FIG. 4C, S23). For example, Ni plating can be employed as the plating, but the plating is not limited to this Ni plating. A conductive coating may be applied by the following method instead of plating. For example, the conductive coating film may be applied on the surfaces with a spray or the like, The conductive coating film may be dissolved and coated on the surfaces. A sheet like conductive coating film may be thermal-compression bonded on the surfaces. However, the second embodiment is explained by using an example of the plating.

After the half-cut notches 8 are formed corresponding to the notches 4 by this plating processing, the ceramic substrate 1 is divided into a plurality of individual electronic components 10 by the slits 3 (FIGS. 4D and 4E, S24) .

In this manufacturing method, it is sufficient to perform the half-cut only once. Accordingly, the productivity is further improved and cost reduction can be achieved in comparison to the first embodiment.

### (Third Embodiment)

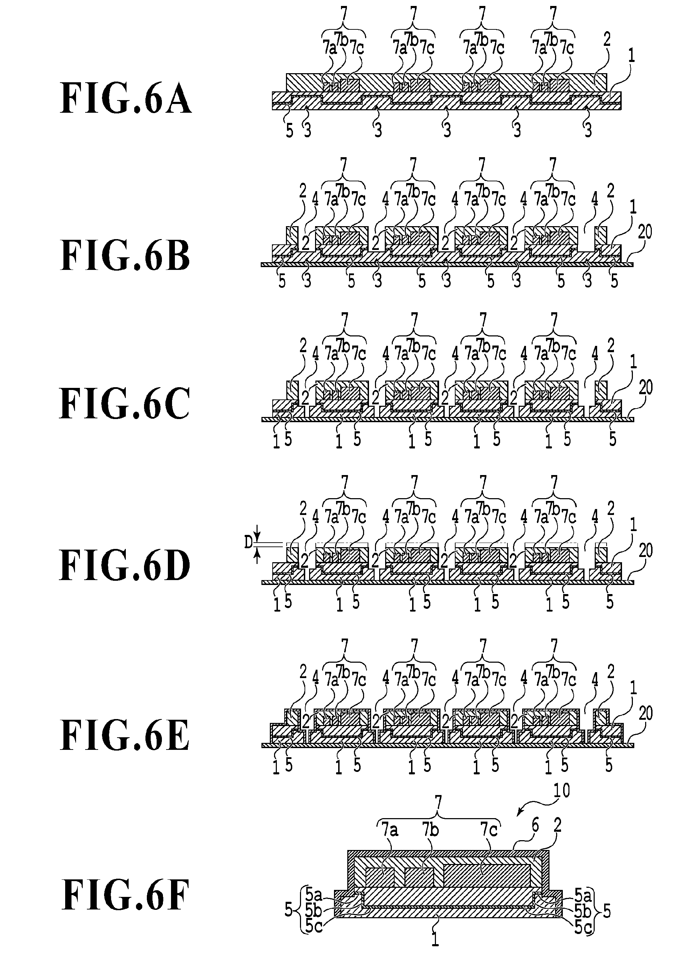

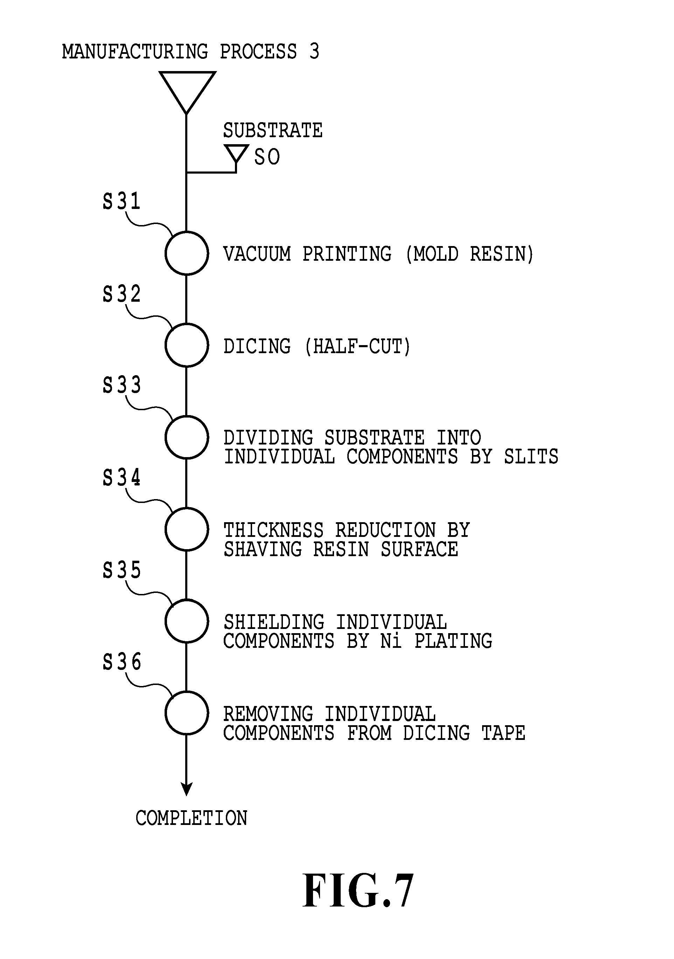

A method of manufacturing an electronic component according to a third embodiment is described by referring to FIGS. 6A to 6F and FIG. 7. FIGS. 6A to 6F are views for explaining steps in the third embodiment and FIG. 7 is a flowchart explaining the steps in the manufacturing method according to the third embodiment. In the third embodiment, unfinished electronic components in an intermediate step are divided from one another into individual components before the plating of the shield film 6, and then the surface of the mold resin layer 2 is shaved by a blade or the like, so that the thickness of the electronic components 10 is further reduced.

First, the notches 4 are formed in the mold resin layer 2 by a half-cut method similar to that in steps S0 to S12 in the first embodiment (FIGS. 6A and 6B, S0, S31, and S32). In this embodiment, when this half-cut is performed, a dicing tape 20 is attached to the bottom surface of the ceramic substrate 1 on which the slits 3 is formed.

The ceramic substrate 1 having the notches 4 is divided into individual components by the slits 3 (FIG. 6C, S33). The top surface of the mold resin layer 2, in each of portions which are divided into individual components and which are also attached to the dicing tape 20, is shaved off by a depth of D by a blade or the like, so that the film thickness of the mold resin layer 2 is reduced by D (FIG. 6D, S34). The shaving depth D is adjusted such that the component part 7 is not exposed as a matter of course.

The shield film 6 is formed on the surface of the shaved-off mold resin layer 2 and the notch 4 by plating (FIG. 6E, S35). The individual electronic components 10 divided from each other are removed from the dicing tape 20, so that a plurality of electronic components 10 are obtained (FIG. 6F, S36).

While the aforementioned embodiments are described by using an example of an arrangement in which the slits 3 are formed before the application of the mold resin layer 2, the slits 3 may be scribed after the application of the mold resin layer 2. In other words, the engraving of the slits 3 may be performed at any step before the step of dividing the ceramic substrate 1 into individual components. For example, at the steps of FIGS. 2A to 2F, the slits 3 may be formed at any of the steps of FIGS. 2A to 2D. At the steps of FIGS. 4A to 4E, the slits 3 may be formed at any of the steps of FIGS. 4A to 4C. At the steps of FIGS. 6A to 6F, the slits 3 may be formed at any of the steps of FIGS. 6A to 6B.

While the present invention has been described with reference to exemplary embodiments, it is to be understood that the invention is not limited to the disclosed exemplary embodiments. The scope of the following claims is to be accorded the broadest interpretation so as to encompass all such modifications and equivalent structures and functions.

Component parts are mounted on a top surface of a ceramic substrate (1) having therein a ground line (5) including a ground layer (5c) electrically connected to a grounding portion (9a) exposed on a bottom surface of the ceramic substrate (1), and then coated with a mold resin layer (2). Half-cut is performed on the ceramic substrate (1) from the surface of the mold resin layer to expose a portion of the ground line from side surface of the ceramic substrate (1). A conductive shield film is so formed to cover the surface of the mold resin layer (2) and the exposed portion of the ground line (5) by the half-cut. A slits (3) for dividing the ceramic substrate (1) into individual electronic components (10)is formed before the dividing the ceramic substrate. The ceramic substrate (1) is divided into the individual electronic components (10) by the slit (3).

## Claims

1. A method of manufacturing an electronic component comprising the steps of:
mounting a plurality of component parts on a first main surface of a ceramic substrate having therein a ground line including a ground layer electrically connected to a grounding portion exposed on a second main surface of the ceramic substrate, and then coating the first main surface of the ceramic substrate with a mold resin layer in such a way that a plurality of component parts are covered with the mold resin layer;
performing half-cut on the ceramic substrate from the surface of the mold resin layer coating the ceramic substrate to expose a portion of the ground line from a side surface of the ceramic substrate;
forming a conductive shield film in such a way that the conductive shield film covers the surface of the mold resin layer and the exposed portion of the ground line exposed by the half-cut;
forming a slit for dividing the ceramic substrate into a plurality of individual electronic components in advance of the dividing the ceramic substrate; and
dividing the ceramic substrate into a plurality of individual electronic components by the slit.

2. The method of manufacturing an electronic component according to claim 1, wherein in the step of forming the conductive shield film, the conductive shield film is formed by applying conductive shield resin by vacuum printing to the surface of the mold resin layer and a surface of the ground layer exposed by the half-cut, ; and then second half-cut is performed on the conductive shield film corresponding to the slit.

3. The method of manufacturing an electronic component according to claim 1, wherein in the step of forming the conductive shield film, conductive shield resin is applied to the surface of the mold resin layer and a surface of the ground layer exposed by the half-cut by plating.

4. The method of manufacturing an electronic component according to any one of claims 1 to 3, wherein the slit is scribed before the ceramic substrate is divided into individual components.

5. The method of manufacturing an electronic component according to any one of claims 1 to 4, wherein the slit is formed as a V-shaped cut by a dicer.
